# FASCICULE DE BREVET EUROPEEN

(11) **EP 0 907 253 B1**
(45) Date de publication et mention de la délivrance du brevet: **05.02.2003**
(21) Numéro de dépôt: 98402392.9
(22) Date de dépôt: 29.09.1998
(51) Int. Cl.: H03L 7/099

(54) **Oscillateur à boucle de verrouillage de phase**
Oszillator für Phasenregelkreis
Oscillator for a phase locked loop

(30) Priorité: 03.10.1997 FR 9712345
(43) Date de publication de la demande: 07.04.1999
(73) Titulaire: THALES AVIONICS S.A., 78141 Vélizy Villacoublay Cédex (FR)
(72) Inventeur: Pitot, Christian, THOMSON -CSF, Prop. Int. Dept., 94117 Arcueil Cedex (FR); Prost, Michel, THOMSON -CSF, Prop. Int. Dept., 94117 Arcueil Cedex (FR)
(74) Mandataire: Beylot, Jacques

(56) Documents cités:
- EP-A- 0 528 283
- GB-A- 2 310 772
- US-A- 5 075 640
- US-A- 5 257 294

## Description

La présente invention concerne les oscillateurs à boucle de verrouillage de phase et notamment ceux destinés à engendrer le signal d'horloge d'un circuit électronique réalisé sur une puce de circuit intégré.

Les performances atteintes à l'heure actuelle, par les techniques d'intégration autorisent l'intégration, sur une puce de circuit intégré, de circuits électroniques à base de combinaisons complexes de circuits logiques effectuant des successions d'opérations à des cadences, dites cadences d'horloge, très élevées qui ne peuvent plus être distribuées de manière synchrone sur des cartes de circuits imprimés car leurs temps de trajet pour parvenir d'une localisation unique aux différentes localisations des puces de circuit intégré et la dispersion entre ces temps de trajet ne sont plus négligeables devant leur période. Cette impossibilité de distribuer, de manière synchrone, sur des cartes de circuit imprimé, les cadences d'horloge très élevées requises par les circuits électroniques intégrés sur des puces pose un problème lorsqu'il s'agit de synchroniser entre eux divers circuits électroniques intégrés sur plusieurs puces réparties sur une ou plusieurs cartes de circuit imprimé.

Pour résoudre ce problème, il est connu de distribuer sur la ou les cartes de circuit imprimé un signal de synchronisation sous-multiple des signaux d'horloge des circuits électroniques intégrés sur des puces et d'intégrer, à la périphérie de chaque puce, un oscillateur à boucle de verrouillage de phase engendrant le signal d'horloge proprement dit du circuit électronique intégré sur la puce considérée, ce signal d'horloge étant verrouillé en phase sur le signal de synchronisation et ayant une cadence multiple de ce dernier adaptée aux performances du circuit électronique intégré sur la puce.

La technique d'intégration des circuits électroniques à base de circuits logiques est très évolutive. Différentes technologies d'intégration, souvent incompatibles entre elles, se partagent le marché à un instant donné, certaines devenant obsolètes et d'autres émergeant au cours du temps, si bien qu'il n'est pas rare, pour assurer la pérennité d'un circuit électronique à base de circuits logiques intégré sur une puce, d'avoir à changer de technologie d'intégration.

Ce changement de technologie d'intégration ne pose pas de problème particulier pour un circuit électronique à base de circuits logiques dans la mesure où, pour chaque technologie d'intégration, il est habituel de développer des bibliothèques de circuits logiques auxquelles il suffit de faire appel pour mener à bien l'intégration. En outre, les plots de connexion qui leur sont dédiés en périphérie d'une puce ne sont pas spécialisés si bien qu'il est toujours possible de récupérer un même brochage pour un composant qu'il soit réalisé avec une technologie d'intégration ou une autre. Ce n'est pas le cas lorsque les circuits qui sont intégrés sur une puce ne se limitent pas à une combinaison de circuits logiques mais comportent d'autres éléments pour lesquels il est fait appel à des techniques d'intégration spécifiques de la technologie employée comme c'est le cas, à l'heure actuelle, des oscillateurs à boucle de verrouillage de phase intégrés en périphérie des puces pour fournir un signal d'horloge. En effet, il est alors difficile de conserver les mêmes caractéristiques électriques pour de tels éléments lors d'un changement de technologie d'intégration. De plus, il se pose souvent un problème de disposition de plots de connexion périphériques, ceux-ci étant la plupart du temps spécialisés et ayant des positions variant avec les technologies d'intégration.

Les oscillateurs à boucle de verrouillage de phase sont cependant très utiles pour obtenir, avec des technologies rapides, des comportements dont les caractéristiques temporelles étaient obtenues auparavant grâce à la relative lenteur des technologies anciennes.

On se retrouve donc dans une situation où les oscillateurs à boucle de verrouillage de phase constituent un obstacle aux changements de technologies d'intégration par ailleurs indispensables pour assurer la pérennité d'un circuit électronique à base de combinaisons de circuits logiques intégré sur une puce.

La présente invention a pour but un oscillateur à boucle à verrouillage de phase qui soit d'une conception facilitant les changements de technologies d'intégration. Pour ce faire, on propose de concevoir un oscillateur à boucle de verrouillage de phase uniquement à l'aide de circuits logiques afin de n'avoir à faire appel pour son intégration, qu'à des bibliothèques de circuits logiques.

Elle a pour objet un oscillateur à boucle à verrouillage de phase comportant:
- un circuit oscillateur comportant deux circuits de propagation de transition à retards programmables, à base de cascades de portes logiques à prises intermédiaires et de multiplexeurs, avec une entrée de données, une entrée de réglage et une sortie de donnée, mis en boucle par l'intermédiaire de deux bascules logiques de type D avec une entrée de donnée D mise au niveau logique 1, une entrée d'horloge CK, une entrée R de remise à zéro, une entrée S de remise à un et une sortie Q de donnée, chaque circuit de propagation de transition à retard programmable contrôlant par sa sortie de donnée l'entrée d'horloge CK de l'une des bascules logiques de type D et l'entrée R de remise à zéro de l'autre bascule logique de type D, et chaque porte logique de type D contrôlant par sa sortie de donnée Q l'entrée de donnée du circuit de propagation de transition à retard programmable contrôlant son entrée R de remise à zéro, et une porte logique de type "et" à deux entrées intercalée entre la sortie Q de données de l'une des bascules logiques de type D et l'entrée du circuit à retard programmable qui lui est connecté de manière à constituer une entrée de commande d'inhibition et de déclenchement de l'oscillation,
- deux compteurs-décompteurs à base de combinaisons de circuits logiques, assurant la commande des entrées de réglage des deux circuits de propagation de transition à retards programmables,
- un circuit diviseur à base de combinaisons de circuits logiques, connecté en sortie du circuit oscillateur, sur la sortie de donnée Q de l'une des bascules logiques de type D
- un circuit comparateur de phase à base de combinaisons de circuits logiques, qui reçoit en entrées le signal de l'oscillateur après division par le circuit diviseur et un signal de référence de phase, et détecte l'état de déphasage entre ces deux signaux, et
- un circuit de décision à base de combinaisons de circuits logiques, qui est commandé par le circuit comparateur de phase et élabore les commandes des circuits compteurs-décompteurs assurant la commande des entrées de réglage des circuits de propagation de transition à retards programmables en fonction de l'état de déphasage détecté par le circuit comparateur de phase.

Grâce à la constitution exclusivement à base de circuits logiques de tous les circuits qui le composent, cet oscillateur à boucle de verrouillage de phase peut être intégré sur une puce de circuits prédiffusés ou précaractérisés au même titre que les circuits électroniques à base de combinaisons de circuits logiques qu'il est destiné à cadencer. De cette manière, il n'est plus nécessaire de faire appel, pour l'intégration d'un oscillateur à boucle à verrouillage de phase, à une technique particulière spécifique de la technologie d'intégration utilisée. On évite ainsi que l'intégration de l'oscillateur à boucle à verrouillage de phase fasse obstacle aux changements inévitables de technologie d'intégration.

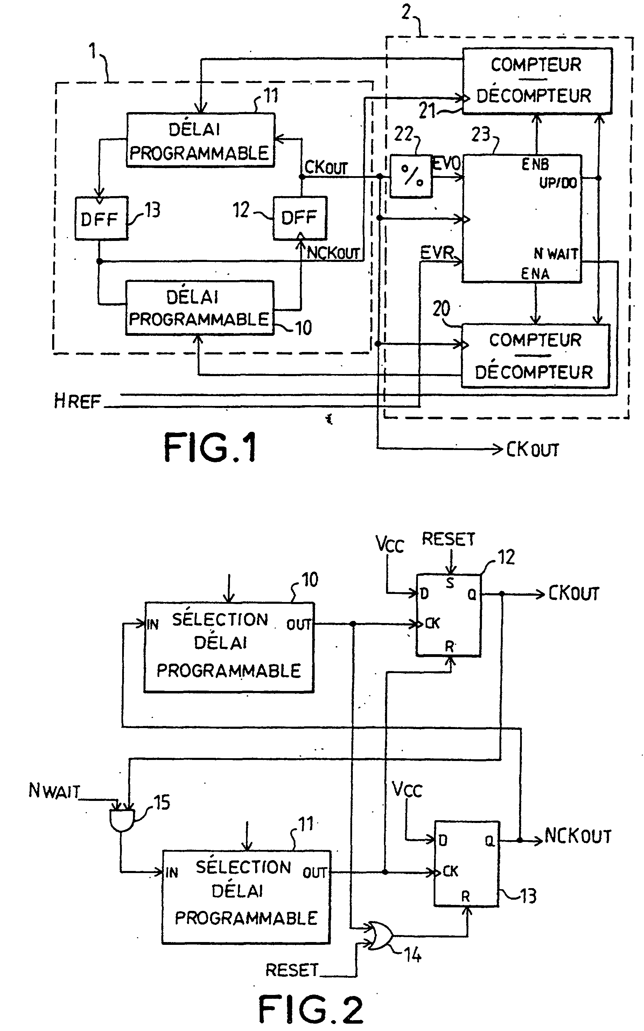

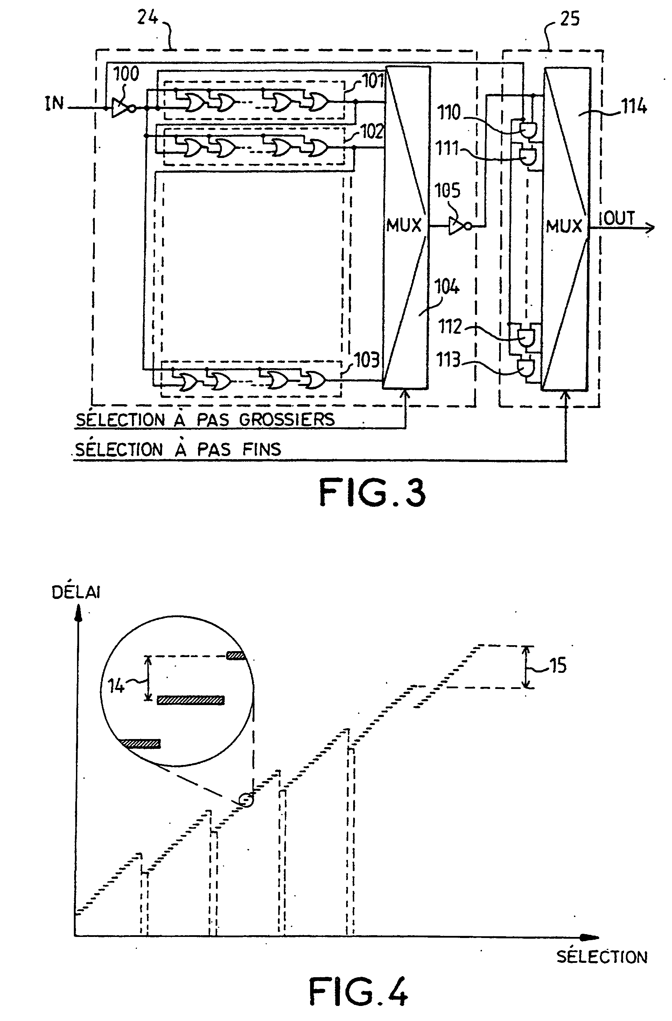

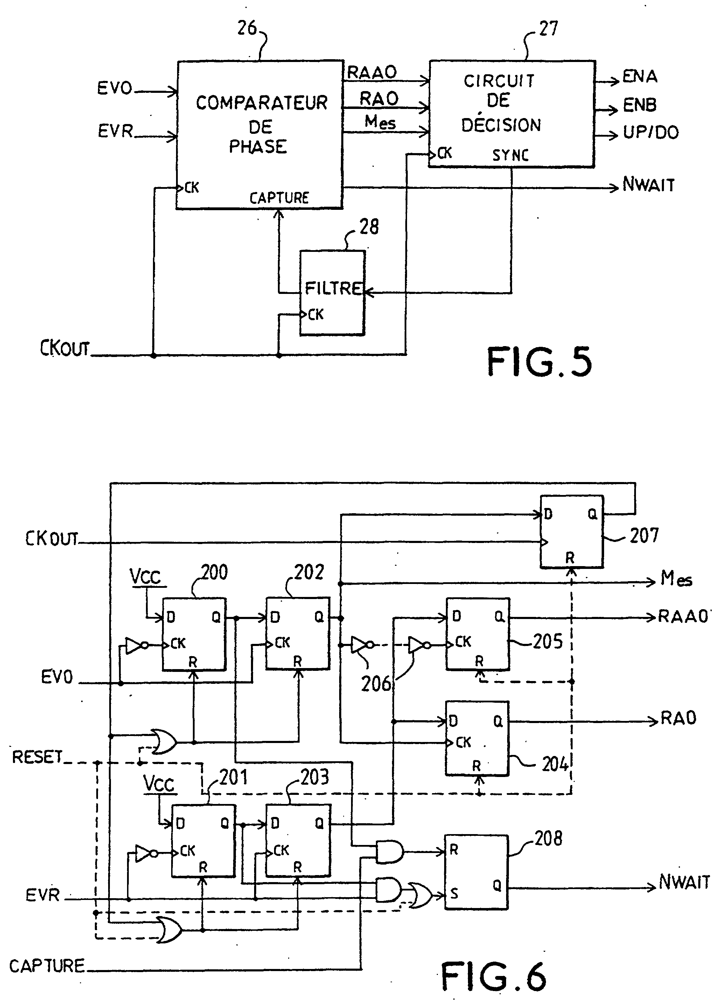

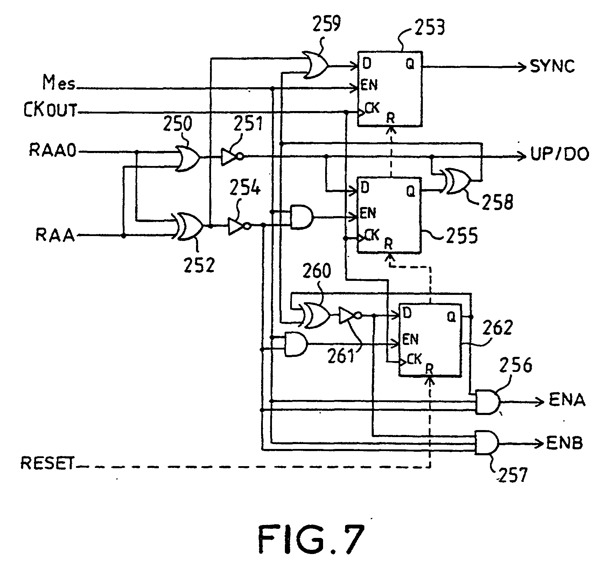

D'autres caractéristiques et avantages de l'invention ressortiront de la description ci-après d'un mode de réalisation donné à titre d'exemple. Cette description sera faite en regard du dessin dans lequel :
- une figure 1 représente le schéma synoptique d'un oscillateur à boucle de verrouillage de phase conforme à l'invention,
- une figure 2 détaille la constitution de la partie oscillateur du schéma de la figure 1,
- une figure 3 détaille la constitution de circuits de propagation de transition à retards programmables apparaissant dans les schémas des figures précédentes,
- une figure 4 est un diagramme illustrant le réglage à deux échelles, l'une grossière et l'autre fine des délais de retard des circuits de propagation de transition à retards programmables,
- une figure 5 détaille la constitution du circuit de commande d'asservissement de phase apparaissant dans le schéma de la figure 1,
- une figure 6 détaille la constitution d'un comparateur de phase faisant partie du circuit de commande d'asservissement de phase représenté à la figure précédente, et
- une figure 7 détaille la constitution d'un circuit de décision placé à la suite du comparateur de phase dans le circuit de commande d'asservissement de phase de la figuré 5.

Comme on peut le voir sur la figure 1, l'oscillateur à boucle de verrouillage de phase se compose d'un oscillateur ajustable en fréquence 1 réalisé uniquement à base de circuits logiques, associé à une boucle d'asservissement de phase 2 également réalisée uniquement à base de circuits logiques.

L'oscillateur 1 délivre un signal d'horloge CKOUT. La boucle d'asservissement de phase 2 reçoit le signal CKOUT issu de l'oscillateur 1, le divise en fréquence, le compare en phase avec un signal de référence HREF puis utilise le résultat de la comparaison de phase pour ajuster la fréquence de l'oscillateur 1.

L'oscillateur ajustable en fréquence 1 comporte essentiellement deux circuits de propagation de transition à retards programmables 10, 11 rebouclés sur eux-mêmes par l'intermédiaire de deux bascules logiques de type D 12, 13. Il sera détaillé ultérieurement en regard de la figure 2.

La boucle à verrouillage de phase 2 se compose principalement de :
- deux compteurs-décompteurs 20, 21 qui délivrent les valeurs des retards des deux circuits de propagation de transition à retards programmables 10, 11 de l'oscillateur 1 et qui sont cadencés alternativement, l'un par le signal de sortie CKOUT de l'oscillateur 1, l'autre par l'inverse NCKOUT du signal de sortie de l'oscillateur de manière à ne changer d'état que lorsque le circuit de propagation de transition auquel ils fournissent une valeur de réglage du retard est au repos,
- un diviseur de fréquence 22 amenant la fréquence du signal de sortie CKOUT de l'oscillateur 1 au voisinage de celle du signal de référence HREF, et
- un circuit 23 de comparaison de phase et de commande des compteurs-décompteurs 20, 21.

Les deux circuits de propagation de transition à retards programmables 10, 11 de l'oscillateur 1 sont identiques. Comme le montre plus précisément la figure 2, ils possèdent chacun une entrée donnée "in", une sortie donnée "out" et une entrée de réglage de leur retard "sélection". Ils sont connectés chacun, 10 respectivement 11, par leur sortie de donnée à l'entrée d'horloge CK de l'une des bascules de type D 12, respectivement 13 et à l'entrée de remise à zéro R de l'autre bascule de type D 13, respectivement 12 tandis que leur entrée donnée est connectée à la sortie donnée Q de la bascule de type D dont ils contrôlent l'entrée de remise à zéro R.

Chaque circuit de propagation de transition à retard programmable 10, respectivement 11 achemine avec un certain retard un type de transition logique, celui auquel est sensible l'entrée d'horloge de la bascule de type D 12, respectivement 13 à laquelle il est connecté par sa sortie de donnée. L'autre type de transition logique ne fait que le réinitialiser. En cours d'oscillation, les deux bascules de type D 12, 13 sont dans des états opposés qui s'échangent. Au démarrage, ces états opposés sont imposés en plaçant la bascule de type D 12 au niveau logique 1 par un ordre de niveau adéquat sur son entrée S de remise à un, et la bascule de type D 13 au niveau logique 0 par un ordre de niveau adéquat sur son entrée R de remise à zéro introduit au moyen d'une porte logique de type "ou" 14 intercalée sur la commande provenant de la sortie du circuit de propagation de transition à retard programmable 10. Ces états opposés ne suffisent pas à créer l'instabilité nécessaire au démarrage de l'oscillation. Celle-ci est provoquée par l'application d'une transition en entrée donnée du circuit de propagation de transition à retard programmable 11 au moyen d'une porte logique de type "et" 15 intercalée sur la commande en provenance de la sortie de donnée Q de la bascule de type "D" 12.

Cette structure particulière d'oscillateur vise à éviter le développement d'oscillations harmoniques parasites. Les circuits de propagation de transition à retards programmables 10, 11 sont actifs alternativement. Lorsqu'ils sont actifs, ils propagent avec retard le type de transition logique auquel sont sensibles les entrées d'horloge CK des bascules de type D 12, 13 puis passent au repos en transmettant sans retard l'autre type de transition logique qui leur est appliqué à la suite de la remise à zéro de la basculé de type D qui contrôle leur entrée de donnée. Ainsi, en cours d'oscillation, il circule, dans la boucle formée par les deux circuits de propagation de transition à retards programmables 10, 11 et les deux bascules de type D 12, 13, une seule transition du type auquel sont sensibles les entrées d'horloge CK des bascules de type D, cette transition provoquant le passage au niveau logique 1 du signal de sortie de l'oscillateur pris sur la sortie de donnée Q de la bascule de type D 12 chaque fois qu'elle parvient en sortie du circuit de propagation de transition à retard programmable 10 et le passage au niveau logique zéro du signal de sortie de l'oscillateur chaque fois qu'elle parvient en sortie du circuit de propagation de transition à retard programmable 11.

La figure 3 détaille la constitution à base de portes logiques et de multiplexeur de chacun des circuits de propagation de transition à retard programmable dans l'hypothèse où la transition à retarder est une transition montante. Chaque circuit de propagation de transition à retard programmable est constitué de deux étages 24 et 25 de dispositifs à retard fonctionnant en série l'un par rapport à l'autre et disposant chacun d'un pas de réglage de retard différent.

Le premier étage de dispositifs à retard 24 comporte :
- un amplificateur inverseur 100 placé en entrée
- une cascade de portes logiques de type "ou" à deux entrées connectées en série par une entrée et en parallèle par l'autre entrée, placées à la suite de l'amplificateur inverseur d'entrée 100 et rassemblées en N groupes d'égale longueur 101, 102, ...,103,
- un multiplexeur 104 à N+1 1 entrées raccordées à la sortie de l'amplificateur inverseur 100 et à celles des N groupes de portes 101, 102,..., 103 permettant d'extraire une transition descendante se propageant le long de la cascade de portes à son passage par l'entrée ou la sortie de l'un quelconque des groupes de portes, et
- un amplificateur inverseur 105 de sortie

L'accès en parallèle à toutes les portes logiques de type "ou" permet de figer rapidement, à l'état de repos, les sorties de tous les groupes de portes au niveau logique 1 au moyen de l'application d'un niveau logique 0 en entrée. Cela garantit au repos un état d'énergie stable à partir duquel la propagation d'une transition montante appliquée en entrée pourra s'effectuer de manière reproductible le long de l'autre chemin dans lequel les portes logique de type "ou" sont en série.

Le schéma représenté ici est particulièrement adapté une technologie CMOS. La propagation d'une transition montante se fait au travers de l'activité de transistors de type P en série à l'intérieur des portes logiques de type "ou". A taille égale, ces dispositifs sont plus lents que des transistors de type N du fait de la plus faible mobilité des porteurs. Cela permet d'obtenir des temps de propagation plus significatifs pour une surface réduite. Le mode de fonctionnement choisi correspond à la propagation d'une transition descendante le long des portes logiques de type "ou", ce qui justifie la présence des amplificateurs inverseurs 100 et 105 d'entrée et de sortie.

Le deuxième étage de dispositifs à retard 25 comporte :
- une cascade de M portes logiques de type "et" 110, 111, 112,..., 113 à deux entrées connectées en série par une entrée et en parallèle par l'autre, et
- un multiplexeur 114 à M+1 entrées connectées à l'entrée de la cascade des M portes logiques de type "et" 110, 111, 112,...,113 et aux sorties des M portes logiques de type "et" 110, 111, 112,..., 113 permettant d'extraire une transition montante se propageant le long de la cascade de portes logiques de type "et" à son passage à l'entrée ou à la sortie de l'une quelconque des portes logiques.

Tout comme le premier étage de dispositifs à retard, l'accès en parallèle à toutes les portes logiques permet de figer rapidement leur état de sortie au repos, ici à l'état logique 0, de façon à garantir au repos un état d'énergie stable à partir duquel la propagation d'une transition montante appliquée en entrée pourra s'effectuer de manière reproductible le long de l'autre chemin dans lequel les portes sont en série.

Dans cet exemple adapté à la technologie CMOS, le deuxième étage de dispositifs à retard est réalisé avec des portes logiques de type "et" de manière à obtenir un retard élémentaire plus faible.

Les deux étages de dispositifs à retard sont dimensionnés de manière à obtenir une plage de délais de largeur supérieure à la dynamique des variations possibles du retard dues à la dispersion intrinsèque des paramètres technologiques et au gammes de température et de tension d'alimentation dans lesquelles le circuit doit pouvoir fonctionner.

Comme le montre le diagramme de la figure 4, les groupes de portes du premier étage de dispositifs à retard sont dimensionnés approximativement de manière à présenter un retard unitaire inférieur à la dynamique de réglage de retard du deuxième étage de dispositifs à retard, cela de manière à faire en sorte que les déplacements du point d'équilibre de la boucle d'asservissement de phase dus au seul bruit de mesure de phase n'entraînent qu'une modification de l'adressage du multiplexeur du deuxième étage. Cette précaution permet une fois l'accrochage de l'oscillateur réalisé, d'asservir son fonctionnement en fréquence et en phase en jouant uniquement sur les pas fins de réglage du retard, ce qui minimise la gigue liée au fonctionnement de l'asservissement.

Dans le diagramme de la figure 4, on a pris pour hypothèse un circuit de propagation de transition à retard programmable à deux étages présentant seize pas unitaires 14 de réglage fin du retard dont la sélection se fait sur 4 bits, et des pas unitaires 15 de réglage grossier du retard inférieurs en durée à la gamme globale des pas unitaires 14 de réglage fin.

Les changements de réglage des retards des circuits de propagation de transition 10, 11 se font uniquement lorsque ces derniers sont en position de repos, c'est-à-dire lorsqu'ils n'acheminent pas de transition montante. Cela est obtenu en faisant fonctionner chaque compteur-décompteur 20, respectivement 21 (figure 1) pendant la période de repos du circuit de propagation de transition 10 respectivement 11 dont il gouverne le retard. Pour ce faire, les compteurs-décompteurs 20, 21 que l'on suppose sensibles à une transition montante d'horloge, reçoivent, comme signaux d'horloge, des versions en opposition de phase du signal de sortie de l'oscillateur, la version CKOUT pour le compteur-décompteur 20 et la version NCKOUT pour le compteur-décompteur 21 et sont commandés par des signaux de validation ENA, ENB et un signal de comptage-décomptage UP/DO délivrés par le circuit 23 de comparaison de phase et de commande.

La figure 5 montre la constitution du circuit de comparaison de phase et de commande 23. Celui-ci peut s'analyser comme constitué de trois circuits logiques cadencés par le signal de sortie CKOUT de l'oscillateur :
- un circuit comparateur de phase 26 opérant des mesures des positions relatives des transitions montantes dans le signal de sortie de l'oscillateur divisé en fréquence EVO et un signal de référence EVR correspondant au signal HREF (figure 1) et délivrant un signal de prise de mesure Mes, deux signaux de comparaison des positions relatives des transitions montantes des signaux mesurés RAAO et RAO, et un signal de déclenchement de capture NWAIT,
- un circuit de décision 27 placé à la suite du comparateur de phase 26 et élaborant les signaux de validation ENA, ENB et de sens de comptage UP/DO destinés aux compteurs-décompteurs 20, 21 et un signal de test de synchronisation SYNC, et
- un circuit de filtrage 28 opérant sur le signal de test de synchronisation engendré par le circuit de décision 27 avant de le retourner en tant que signal de capture au comparateur de phase 26.

Un schéma du circuit comparateur de phase 26 prévu pour la détection des relations de phase entre les transitions montantes du signal issu de la division de l'oscillateur EVO et du signal de référence EVR qui sont les transitions actives dans l'exemple de réalisation détaillé ici, est donné à la figure 6. Avec ce schéma de circuit comparateur de phase, la détection des relations de phase se fait en quatre étapes dont les trois premières correspondent à trois étages de bascules logiques de type D successifs.

La première étape se déroule indépendamment pour les deux signaux EVO et EVR. Elle consiste à attendre et mémoriser l'apparition d'une transition descendante dans chacun des signaux EVO et EVR grâce à un premier étage de bascules logiques de type D, la bascule logique de type D 200 pour le signal EVO et la bascule logique de type D 201 pour le signal EVR.

La deuxième étape, qui se déroule également de façon indépendante pour les deux signaux EVO et EVR, consiste en la détection ultérieure d'une transition montante dans chacun des signaux EVO et EVR. Elle est réalisée à l'aide d'un deuxième étage de bascules logiques de type D, la bascule logique de type D 202 pour le signal EVO et la bascule logique de type D 203 pour lé signal EVR. Chaque transition montante du signal EVO issu de la division de l'oscillateur déclenche une prise de mesure de comparaison de phase signalée au circuit de décision 27 par un signal Mes engendré par la bascule logique de type D 202.

La troisième étape, qui est l'étape de comparaison de phase proprement dite, utilise un troisième étage de bascules logiques de type D, les bascules logiques de type D 204 et 205. La première bascule de type D 204 échantillonne le niveau logique du signal de référence EVR à l'apparition d'une transition montante du signal EVO issu de la division de l'oscillateur et délivre un signal RAO. La seconde bascule logique de type D 205 échantillonne le niveau logique du signal de référence EVR avec un certain retard sur la première et délivre un signal RAAO. Le retard de l'instant d'échantillonnage de la deuxième bascule 205 par rapport à la première 204 est dimensionné pour éviter que les deux bascules 204, 205 puissent se situer toutes deux dans un cas d'indétermination (état métastable). Il est obtenu en interposant devant l'entrée d'horloge de la deuxième bascule 205 un certain nombre de couches logiques 206. A l'issue de la comparaison de phase, trois situations sont possibles :
- Les deux bascules 204 et 205 sont toutes les deux au niveau logique 1. On en déduit que la transition montante du signal de référence EVR est antérieure à celle du signal EVO issu de la division de l'oscillateur.
- Les deux bascules 204 et 205 sont toutes les deux au niveau logique 0. On en déduit que la transition montante du signal de référence EVR est postérieure à celle du signal EVO issu de la division de l'oscillateur.
- Les deux bascules 204 et 205 ont des états antagonistes, la bascule 204 étant au niveau logique 0 et la bascule 205 au niveau logique 1. On en déduit que les transitions montantes du signal de référence EVR et du signal EVO issu de la division de l'oscillateur sont simultanées.

A la fin de la phase de mesure, le circuit comparateur de phase est réinitialisé au moyen d'une bascule logique de type D 207 dont l'entrée D est connectée à la sortie Q de la bascule de type D 202 mémorisant échantillonnant les transitions montantes du signal EVO issu de la division de l'oscillateur et dont l'entrée d'horloge CK reçoit le signal CKOUT de l'oscillateur.

Une bascule logique de type RS 208 permet d'engendrer un signal d'attente NWAIT actif au niveau logique 0 ayant pour fonction de prolonger l'état de repos de l'une des branches de l'oscillateur, celle qui contient le circuit de propagation de transition à retard programmable 11 et qui démarre normalement son état actif sur une transition montante du signal de sortie CKOUT de l'oscillateur. Ce signal NWAIT est activé en présence d'un signal de capture après l'apparition d'une transition descendante dans le signal EVO issu de la division de l'oscillateur. Il est désactivé par une remise à zéro du circuit comparateur de phase ou par la survenue d'une transition montante dans le signal de référence EVR consécutive à une transition descendante de ce même signal de référence.

Un schéma de circuit de décision 27 est donné à la figure 7. Il est conçu pour mettre en oeuvre un algorithme de décision basé sur trois règles de fonctionnement :
- émission d'un ordre de comptage lorsque la transition montante du signal EVO issu de la division de l'oscillateur est antérieure à la transition montante du signal de référence EVR, c'est-à-dire lorsque les signaux RAO et RAAO sont tous les deux au niveau logique 0,
- émission d'un ordre de décomptage lorsque la transition montante du signal EVO issu de la division de l'oscillateur est postérieure à la transition montante du signal de référence EVR, c'est-à-dire lorsque les signaux RAO et RAAO sont tous les deux au niveau logique 1,
- absence d'ordre de comptage ou de décomptage en cas de simultanéité des transitions montantes du signal EVO issu de la division de l'oscillateur et du signal de référence EVR, c'est-à-dire lorsque les signaux RAO et RAAO sont à des niveaux logiques opposés,
cela sachant que l'on ne doit modifier le réglage du retard que d'une seule branche de l'oscillateur à la fois et que, si un ordre courant de comptage ou de décomptage est de même nature que le précédent issu de la dernière mesure significative, il faut l'appliquer à la branche opposée de l'oscillateur tandis que si l'ordre courant est de nature opposée, il faut l'appliquer sur la même branche de l'oscillateur pour éviter une dérive du rapport cyclique du signal issu de l'oscillateur.

L'ordre de comptage décomptage UP/DO est obtenu au moyen d'une porte logique 250 de type "ou" à deux entrées qui est suivie d'un amplificateur inverseur 251 et qui reçoit sur ses deux entrées les signaux RAO et RAAO.

Une première porte logique de type "ou exclusif" 252 détecte l'état de simultanéité des transitions montantes des signaux EVO et EVR correspondant à des niveaux logiques différents sur les signaux RAO et RAAO. Son signal de sortie est échantillonné par une bascule logique de type D 253 pour engendrer un signal de détection de synchronisme SYNC. Il est également utilisé, après avoir été inversé par un amplificateur inverseur 254, d'une part pour débloquer une bascule logique de type D 255 qui mémorise le sens comptage-décomptage de la dernière correction effective et, d'autre part pour débloquer des portes logiques de type "et" 256, 257 délivrant des ordres de déblocage ENA et ENB à destination des compteurs-décompteurs 20, 21 (figure 1).

Une deuxième porte logique de type "ou exclusif" 258 détecte un changement de sens de l'ordre de comptage-décomptage UP/DO. Son signal de sortie est appliqué par l'intermédiaire d'une porte logique de type "ou" 259 en entrée D de la bascule logique de type D 253 pour qu'elle engendre également un signal de synchronisme SYNC lorsque deux ordres successifs de comptage-décomptage UP/DO sont de natures opposées.

Une troisième porte logique de type "ou exclusif" 260 suivie d'un amplificateur inverseur 261 et combinée avec une bascule logique de type D 262 mémorise la branche de l'oscillateur sur laquelle a été effectuée la dernière correction et commande les portes logiques de type "et" 256, 257 de manière à débloquer l'une de ces deux portes, alternativement l'une puis l'autre lorsque l'ordre courant de comptage ou de décomptage UP/DO est de même nature que le précédent issu de la dernière mesure significative ou toujours la même lorsque l'ordre courant de comptage ou de décomptage UP/DO est de nature opposée au précédent issu de la dernière mesure significative.

Le signal de synchronisation SYNC disponible en sortie de la bascule logique de type D 253, qui signale l'accrochage de la boucle à verrouillage de phase, est utilisé comme signal de capture par le circuit comparateur de phase (figure 6) après avoir été filtré (filtre 28 figure 5) pour en éliminer le bruit.

L'oscillateur à boucle de verrouillage de phase qui vient d'être décrit ne fait appel qu'à des circuits logiques. Il est donc intégrable dans un circuit prédiffusé ou précaractérisé selon la méthode habituelle utilisée pour les circuits de combinaison de portes et bascules logiques auxquels sont plus particulièrement destinés les circuits prédiffusés ou précaractérisés. Grâce à cette propriété, il est transposable d'une technologie d'intégration à une autre au même titre que les circuits de combinaison de portes et bascules logique sans poser de problèmes spécifiques autres que d'adaptation des chaînes de retard à la rapidité de la technologie cible et aux fréquences visées pour le fonctionnement de l'oscillateur.

## Revendications

1. Oscillateur à boucle à verrouillage de phase **caractérisé en ce qu'**il comporte :
- un circuit oscillateur comportant deux circuits de propagation de transition à retards programmables (10, 11), à base de cascades de portes logiques à prises intermédiaires et de multiplexeurs, avec une entrée de données, une entrée de réglage et une sortie de donnée, mis en boucle par l'intermédiaire de deux bascules logiques de type D (12, 13) avec une entrée de donnée D mise au niveau logique 1, une entrée d'horloge CK, une entrée R de remise à zéro, une entrée S de remise à un et une sortie Q de donnée, chaque circuit de propagation de transition à retard programmable (10, respectivement 11) contrôlant par sa sortie de donnée l'entrée d'horloge CK de l'une des bascules logiques de type D (12 respectivement 13) et l'entrée R de remise à zéro de l'autre bascule logique de type D (13 respectivement 12), et chaque porte logique de type D (12 respectivement 13) contrôlant par sa sortie de donnée Q l'entrée de donnée du circuit de propagation de transition à retard programmable (11 respectivement 10) contrôlant son entrée R de remise à zéro, et une porte logique de type "et" (15) à deux entrées -intercalée entre la sortie Q de données de l'une (12) des bascules logiques de type D et l'entrée du circuit à retard programmable (10) qui lui est connecté de manière à constituer une entrée de commande d'inhibition et de déclenchement de l'oscillation,
- deux compteurs-décompteurs (20, 21) à base de combinaisons de circuits logiques, assurant la commande des entrées de réglage des deux circuits de propagation de transition à retards programmables (10, 11),
- un circuit diviseur (22) à base de combinaisons de circuits logiques, connecté en sortie du circuit oscillateur, sur la sortie de donnée Q de l'une (12) des bascules logique de type D
- un circuit comparateur de phase (26) à base de combinaisons de circuits logiques, qui reçoit en entrées le signal de l'oscillateur après division par le circuit diviseur (22) et un signal de référence de phase, et détecte l'état de déphasage entré ces deux signaux, et
- un circuit de décision (27) à base de combinaisons de circuits logiques, qui est commandé par le circuit comparateur de phase (26) et élabore les commandes des circuits compteurs-décompteurs (20, 21) assurant la commande des entrées de réglage des circuits de propagation de transition à retards programmables (10, 11) en fonction de l'état de déphasage détecté par le circuit comparateur de phase (26).

2. Oscillateur selon la revendication 1, **caractérisé en ce que** chaque circuit de propagation de transition à retard programmable (10, 11) comporte au moins une cascade de portes logiques à deux entrées et une sortie, connectées en série par une entrée et en parallèle par l'autre entrée, et un multiplexeur dont les entrées sont connectées en entrée, en sortie et sur des prises intermédiaires de ladite cascade de portes.

3. Oscillateur selon la revendication 2, **caractérisé en ce que** ladite cascade est constituées de portes logiques de type "ou".

4. Oscillateur selon la revendication 2, **caractérisé en ce que** la dite cascade est constituée de portes logiques de type "et".

5. Oscillateur selon la revendication 1, **caractérisé en ce que** chaque circuit de propagation de transition à retard programmable (10, 11) comporte deux étages successifs de dispositifs à retard, un premier étage (24) à pas de réglage grossier et un deuxième étage (25) à pas de réglage fin.

6. Oscillateur selon la revendication 5, **caractérisé en ce que** l'amplitude de la gamme de réglage du retard du deuxième étage est supérieure à la valeur d'un pas de réglage grossier du premier étage.

7. Oscillateur selon la revendication 1, avec des circuits de propagation de transition à retards programmables (10, 11) adaptés à la propagation retardée de transitions montantes, **caractérisé en ce que** chaque circuit de propagation de transition à retard programmable (10, 11) comporte
- un amplificateur inverseur d'entrée (100),
- une cascade de portes logiques de type "ou" à deux entrées et une sortie connectées en série par une entrée et en parallèle par l'autre en sortie de l'amplificateur inverseur (100),
- un multiplexeur (104) à multiples entrées et une sortie, connecté par ses entrées en entrée, en sortie et sur des prises intermédiaires de la cascade de portes logiques de type "ou", et
- un amplificateur inverseur de sortie (105) connecté en sortie du multiplexeur (104).

8. Oscillateur selon la revendication 1, avec des circuits de propagation de transition à retards programmables (10, 11) adaptés à la propagation retardée de transitions'montantes, **caractérisé en ce que** chaque circuit de propagation de transition à retard programmable (10, 11) comporte :
- une cascade de portes logiques de type "et" à deux entrées et une sortie (110, 111,..., 112, 113), connectées en série par une entrée et en parallèle par l'autre, et
- un multiplexeur (114) à multiples entrées et une sortie, connecté par ses entrées en entrée, en sortie et sur des prises intermédiaires de la cascade de portes logiques de type "et".

9. Oscillateur selon la revendication 1, avec des circuits de propagation de transition à retards programmables (10, 11) adaptés à la propagation retardée de transitions montantes, **caractérisé en ce que** chaque circuit de propagation de transition à retard programmable (10, 11) comporte deux étages successifs de dispositifs à retard (24, 25), l'un (24) des étages comportant:
- un amplificateur inverseur d'entrée (100),
- une cascadé de portes logiques de type "ou" à deux entrées et une sortie connectées en série par une entrée et en parallèle par l'autre en sortie de l'amplificateur inverseur (100),
- un multiplexeur (104) à multiples entrées et une sortie, connecté par ses entrées en entrée, en sortie et sur des prises intermédiaires de la cascade de portes logiques de type "ou", et
- un amplificateur inverseur de sortie (105) connecté en sortie du multiplexeur (104).
et l'autre étage (25) de dispositifs à retard comportant
- une cascade de portes logiques de type "et" à deux entrées et une sortie (110, 111,..., 112, 113), connectées en série par une entrée et en parallèle par l'autre, et
- un multiplexeur (114) à multiples entrées et une sortie, connecté par ses entrées en entrée, en sortie et sur des prises intermédiaires de la cascade de portes logiques de type "et".

10. Oscillateur selon la revendication 1, **caractérisé par le fait que** le circuit comparateur de phase (26) comporte deux bascules logiques de type D (204, 205) évaluant la phase relative du signal de référence de phase par rapport au signal de l'oscillateur après division, la mesure de l'une (205) des bascules logiques de type D étant biaisée au moyen d'une chaîne de retard (206) qui est insérée en amont de son entrée d'horloge et qui engendre un retard d'une durée telle que l'une au moins des deux bascules de type D (204, 205) ait un comportement déterministe quelles que soient les phases respectives du signal de référence de phase et du signal de l'oscillateur après division.

## Patentansprüche

1. Oszillator mit Phasenverriegelungsschleife, **dadurch gekennzeichnet, daß** er aufweist:
- eine Oszillatorschaltung mit zwei Schaltungen (10, 11) zur Übergangsausbreitung mit programmierbarer Verzögerung auf der Basis von Kaskaden logischer Tore mit Zwischenabgriffen und von Multiplexern, mit einem Dateneingang, einem Regeleingang und einem Datenausgang, wobei die beiden Schaltungen zur Übergangsausbreitung mit programmierbarer Verzögerung über zwei logische Kippstufen (12, 13) in Schleife geschaltet sind, die einen Dateneingang D für den logischen Wert 1, einen Takteingang CK, einen Nullsetzungseingang R und einen Stelleingang S auf den Wert 1 sowie einen Datenausgang Q besitzen, wobei jede Schaltung zur Übergangsausbreitung mit programmierbarer Verzögerung (10, 11) über ihren Datenausgang den Takteingang CK einer der logischen Kippstufen (12 beziehungsweise 13) vom Typ D sowie den Nullsetzungseingang R der anderen Kippstufe (13 beziehungsweise 12) vom Typ D kontrolliert und jede logische Kippstufe (12 beziehungsweise 13) vom Typ D über ihren Datenausgang Q den Dateneingang der Schaltung zur Übergangsausbreitung mit programmierbarer Verzögerung (11 beziehungsweise 10) kontrolliert, die ihrerseits den Nullsetzungseingang R kontrolliert, und ein logisches Und-Tor (15) mit zwei Eingängen, das zwischen den Datenausgang Q der einen (12) der logischen Kippstufen vom Typ D und den Eingang der Schaltung zur Übergangsausbreitung mit programmierbarer Verzögerung (10) eingefügt ist, die an sie angeschlossen ist, sodaß sie einen Steuereingang zur Blockierung beziehungsweise zur Freigabe der Oszillatorschwingung bildet,
- zwei Vorwärts/Rückwärtszähler (20, 21) auf der Basis von Kombinationen logischer Schaltungen, die die Regeleingänge der beiden Schaltungen (10, 11) zur Übergangsausbreitung mit programmierbarer Verzögerung steuern,
- eine Teilerschaltung (22) auf der Basis von Kombinationen logischer Schaltungen, die an den Ausgang der Oszillatorschaltung am Datenausgang Q einer (12) der logischen Kippstufen vom Typ D angeschlossen ist,
- eine Phasenkomparatorschaltung (26) auf der Basis von Kombinationen logischer Schaltungen, die eingangsseitig das Oszillatorsignal nach Frequenzteilung in der Teilerschaltung (22) und ein Phasenbezugssignal empfängt und die Phasenlage zwischen diesen beiden Signalen erfaßt,
- und eine Entscheidungsschaltung (27) auf der Basis von Kombinationen logischer Schaltungen, die von der Phasenkomparatorschaltung (26) gesteuert wird und die Befehle für die Vorwärts/Rückwärtszähler (20, 21) erarbeitet, sodaß die Steuerung der Regeleingänge der Schaltungen zur Übergangsausbreitung mit programmierbarer Verzögerung (10, 11) abhängig von der Phasenlage gewährleistet wird, die von der Phasenkomparatorschaltung (26) erfaßt wurde.

2. Oszillator nach Anspruch 1, **dadurch gekennzeichnet, daß** jede Schaltung zur Übergangsausbreitung mit programmierbarer Verzögerung (10, 11) mindestens eine Kaskade von logischen Toren mit zwei Eingängen und einem Ausgang, die über einen Eingang in Reihe und über den anderen parallelgeschaltet sind, sowie einen Multiplexer besitzt, dessen Eingänge an den Eingang, den Ausgang und die Zwischenabgriffe der Kaskade von Toren angeschlossen sind.

3. Oszillator nach Anspruch 2, **dadurch gekennzeichnet, daß** die Kaskade aus logischen Oder-Toren besteht.

4. Oszillator nach Anspruch 2, **dadurch gekennzeichnet, daß** die Kaskade aus logischen Und-Toren besteht.

5. Oszillator nach Anspruch 1, **dadurch gekennzeichnet, daß** jede Schaltung zur Übergangsausbreitung mit programmierbarer Verzögerung (10, 11) zwei aufeinanderfolgende Stufen von Verzögerungsvorrichtungen enthält, nämlich eine erste Stufe (24) mit groben Regelschritten und eine zweite Stufe (25) mit feinen Regelschritten.

6. Oszillator nach Anspruch 5, **dadurch gekennzeichnet, daß** die Amplitude des Regelbereichs für die Verzögerung der zweiten Stufe größer als der Wert eines groben Regelschritts der ersten Stufe ist.

7. Oszillator nach Anspruch 1 mit Schaltungen (10, 11) zur Übergangsausbreitung mit programmierbarer Verzögerung, die an die verzögerte Ausbreitung von ansteigenden Übergängen angepaßt sind, **dadurch gekennzeichnet, daß** jede Schaltung zur Übergangsausbreitung mit programmierbarer Verzögerung (10, 11) aufweist:
- einen Inverter-Verstärker (100) am Eingang,
- eine Kaskade von logischen Oder-Toren mit je zwei Eingängen und einem Ausgang, die über einen Eingang in Reihe und über den anderen Eingang parallel an den Ausgang des Inverter-Verstärkers (100) angeschlossen sind,
- einen Multiplexer (104) mit zahlreichen an den Eingang, den Ausgang und die Zwischenabgriffe der Kaskade von logischen Oder-Toren angeschlossenen Eingängen und einem Ausgang,
- und einen Inverter-Verstärker (105), der an den Ausgang des Multiplexers (104) angeschlossen ist.

8. Oszillator nach Anspruch 1 mit Schaltungen (10, 11) zur Übergangsausbreitung mit programmierbarer Verzögerung, die an die verzögerte Ausbreitung von ansteigenden Übergängen angepaßt sind, **dadurch gekennzeichnet, daß** jede Schaltung zur Übergangsausbreitung mit programmierbarer Verzögerung (10, 11) aufweist:
- eine Kaskade von logischen Und-Toren (110, 111, ..., 112, 113) mit je zwei Eingängen und einem Ausgang, die über einen Eingang in Reihe und über den anderen Eingang parallelgeschaltet sind,
- und einen Multiplexer (114) mit zahlreichen an den Eingang, den Ausgang und die Zwischenabgriffe der Kaskade von logischen Und-Toren angeschlossenen Eingängen und einem Ausgang.

9. Oszillator nach Anspruch 1 mit Schaltungen (10, 11) zur Übergangsausbreitung mit programmierbarer Verzögerung, die an die verzögerte Ausbreitung von ansteigenden Übergängen angepaßt sind, **dadurch gekennzeichnet, daß** jede Schaltung zur Übergangsausbreitung mit programmierbarer Verzögerung (10, 11) zwei aufeinanderfolgende Stufen (24, 25) von Verzögerungsvorrichtungen aufweist, von denen die erste Stufe enthält:
- einen Inverter-Verstärker (100) am Eingang,
- eine Kaskade von logischen Oder-Toren mit je zwei Eingängen und einem Ausgang, die über einen Eingang in Reihe und über den anderen Eingang parallel an den Ausgang des Inverter-Verstärkers (100) angeschlossen sind,
- einen Multiplexer (104) mit zahlreichen an den Eingang, den Ausgang und die Zwischenabgriffe der Kaskade von logischen Oder-Toren angeschlossenen Eingängen und einem Ausgang,
- und einen Inverter-Verstärker (105), der an den Ausgang des Multiplexers (104) angeschlossen ist,
während die andere Stufe (25) von Verzögerungsvorrichtungen enthält:
- eine Kaskade von logischen Und-Toren (110, 111, ..., 112, 113) mit je zwei Eingängen und einem Ausgang, die über einen Eingang in Reihe und über den anderen Eingang parallelgeschaltet sind,
- und einen Multiplexer (114) mit zahlreichen an den Eingang, den Ausgang und die Zwischenabgriffe der Kaskade von logischen Und-Toren angeschlossenen Eingängen und einem Ausgang.

10. Oszillator nach Anspruch 1, **dadurch gekennzeichnet, daß** die Phasenkomparator (26) zwei logische Kippstufen (204, 205) vom Typ D aufweist, die die relative Phase des Phasenbezugssignals bezüglich des Signals des Oszillators nach der Frequenzteilung ermitteln, wobei die Messung einer der logischen Kippstufen (205) vom Typ D mithilfe einer Verzögerungskette (206) verzögert wird, die vor dem Takteingang eingefügt ist und eine Verzögerung einer solchen Dauer hervorruft, daß mindestens eine der beiden Kippstufen (204, 205) vom Typ D unabhängig von den Phasen des Phasenbezugssignals und des frequenzgeteilten Oszillatorsignals ein deterministisches Verhalten hat.

## Claims

1. Phase locked loop oscillator **characterized in that** it comprises:
- an oscillator circuit comprising two transition propagation circuits with programmable delays (10, 11), based on cascades of logic gates with intermediate taps and on multiplexers, with a data input, an adjustment input and a data output, which are looped by way of two D type logic flip-flops (12, 13) with a data input D set to the logic 1 level, a clock input CK, a reset to zero input R, a reset to one input S and a data output Q, each transition propagation circuit with programmable delay (10, respectively 11) controlling via its data output the clock input CK of one of the D type logic flip-flops (12 respectively 13) and the reset to zero input R of the other D type logic flip-flop (13 respectively 12), and each D type logic gate (12 respectively 13) controlling via its data output Q the data input of the transition propagation circuit with programmable delay (11 respectively 10) controlling its reset to zero input R, and a two-input "and" type logic gate (15) interposed between the data output Q of one (12) of the D type logic flip-flops and the input of the circuit with programmable delay (10) which is connected thereto in such a way as to constitute a control input for disabling and for triggering the oscillation,
- two forward/backward counters (20, 21) based on combinations of logic circuits, ensuring the control of the adjustment inputs of the two transition propagation circuits with programmable delays (10, 11),
- a divider circuit (22) based on combinations of logic circuits, connected at the output of the oscillator circuit, to the data output Q of one (12) of the D type logic flip-flops
- a phase comparator circuit (26) based on combinations of logic circuits, which receives as inputs the signal from the oscillator after division by the divider circuit (22) and a phase reference signal, and detects the state of phase shift between these two signals, and
- a decision circuit (27) based on combinations of logic circuits, which is controlled by the phase comparator circuit (26) and formulates the commands for the forward/backward counter circuits (20, 21) ensuring the control of the adjustment inputs of the transition propagation circuits with programmable delays (10, 11) as a function of the state of phase shift detected by the phase comparator circuit (26).

2. Oscillator according to Claim 1, **characterized in that** each transition propagation circuit with programmable delay (10, 11) comprises at least one cascade of logic gates with two inputs and one output, which are connected in series by one input and in parallel by the other input, and a multiplexer whose inputs are connected at input, at output and to intermediate taps of the said cascade of gates.

3. Oscillator according to Claim 2, **characterized in that** the said cascade consists of "or" type logic gates.

4. Oscillator according to Claim 2, **characterized in that** the said cascade consists of "and" type logic gates.

5. Oscillator according to Claim 1, **characterized in that** each transition propagation circuit with programmable delay (10, 11) comprises two successive stages of delay devices, a first stage (24) with coarse adjustment interval and a second stage (25) with fine adjustment interval.

6. Oscillator according to Claim 5, **characterized in that** the amplitude of the range of adjustment of the delay of the second stage is greater than the value of a coarse adjustment interval of the first stage.

7. Oscillator according to Claim 1, with transition propagation circuits with programmable delays (10, 11) which are adapted to the delayed propagation of upward transitions, **characterized in that** each transition propagation circuit with programmable delay (10, 11) comprises:
- an input inverter amplifier (100),
- a cascade of "or" type logic gates with two inputs and one output which are connected in series by one input and in parallel by the other at output of the inverter amplifier (100),
- a multiplexer (104) with multiple inputs and one output, which is connected by its inputs at input, at output and to intermediate taps of the cascade of "or" type logic gates, and
- an output inverter amplifier (105) connected at output of the multiplexer (104).

8. Oscillator according to Claim 1, with transition propagation circuits with programmable delays (10, 11) which are adapted to the delayed propagation of upward transitions, **characterized in that** each transition propagation circuit with programmable delay (10, 11) comprises:
- a cascade of "and" type logic gates with two inputs and one output (110, 111, ..., 112, 113), which are connected in series by one input and in parallel by the other, and
- a multiplexer (114) with multiple inputs and one output, which is connected by its inputs at input, at output and to intermediate taps of the cascade of "and" type logic gates.

9. Oscillator according to Claim 1, with transition propagation circuits with programmable delays (10, 11) which are adapted to the delayed propagation of upward transitions, **characterized in that** each transition propagation circuit with programmable delay (10, 11) comprises two successive stages of delay devices (24, 25), one (24) of the stages comprising:
- an input inverter amplifier (100),
- a cascade of "or" type logic gates with two inputs and one output which are connected in series by one input and in parallel by the other at output of the inverter amplifier (100),
- a multiplexer (104) with multiple inputs and one output, which is connected by its inputs at input, at output and to intermediate taps of the cascade of "or" type logic gates, and
- an output inverter amplifier (105) connected at output of the multiplexer (104),
and the other stage (25) of delay devices comprising:
- a cascade of "and" type logic gates with two inputs and one output (110, 111, ..., 112, 113), which are connected in series by one input and in parallel by the other, and
- a multiplexer (114) with multiple inputs and one output, which is connected by its inputs at input, at output and to intermediate taps of the cascade of "and" type logic gates.

10. Oscillator according to Claim 1, **characterized in that** the phase comparator circuit (26) comprises two D type logic flip-flops (204, 205) evaluating the relative phase of the phase reference signal with respect to the signal from the oscillator after division, the measurement of one (205) of the D type logic flip-flops being biased by means of a delay pathway (206) which is inserted upstream of its clock input and which engenders a delay of a duration such that one at least of the two D type flip-flops (204, 205) has a deterministic behaviour whatever the respective phases of the phase reference signal and of the signal from the oscillator after division.
